# EUROPEAN PATENT APPLICATION

(11) **EP 1 605 514 A1**
(43) Date of publication of application: **14.12.2005**
(21) Application number: 04719094.7
(22) Date of filing: 10.03.2004
(51) Int. Cl.: H01L 27/146, H01L 23/12, H01L 31/10, G01T 1/20

(54) **PHOTODIODE ARRAY, METHOD FOR MANUFACTURING SAME, AND RADIATION DETECTOR**

(30) Priority: 10.03.2003 JP 2003063708
(71) Applicant: HAMAMATSU PHOTONICS K.K., Hamamatsu-shi, Shizuoka-ken 435-8558 (JP)
(72) Inventor: SHIBAYAMA, Katsumi, c/o Hamamatsu Photonics K.K., Hamamatsu-shi, Shizuoka, 4358558 (JP)
(74) Representative: Frost, Alex John
(86) International application number: PCT/JP2004/003115
(87) International publication number: WO 2004/082024

(57) **Abstract**

A theme is to prevent the generation of noise due to damage in a photodetecting portion in a mounting process in a photodiode array, a method of manufacturing the same, and a radiation detector. In a photodiode array, wherein a plurality of photodiodes (4) are formed in array form on a surface at a side of an n-type silicon substrate (3) onto which light to be detected is made incident and penetrating wirings (8), which pass through from the incidence surface side to the back surface side, are formed for the photodiodes (4), recessed portions (6) of a predetermined depth that are depressed with respect to regions at which the respective photodiodes (4) are not formed are disposed at the incidence surface side, and the photodiodes (4) are disposed in the recessed portions (6) to arrange the photodiode array (1).

## Description

### Technical Field

This invention concerns a photodiode array, a method of manufacture thereof, and a radiation detector.

### Background Art

Among photodiode arrays, there is known since priorly a front surface incidence type photodiode array, wherein output signals from the photodiode array are electrically connected to the back surface side by means of penetrating wirings (electrodes) that connect a light-incident surface side and a back surface side (see, for example, Japanese Published Unexamined Patent Application No. 2001-318155). As shown in FIG. 19, with the photodiode array disclosed in this publication, wirings 152 are formed on a front surface of the photodiode array 144 to take out signals from the respective diffusion layers 151 where the photodiodes 144a, 144b, 144c, ... 144n, which are the main bodies of a photoelectric conversion unit, are formed, and each wiring 152 is extended so as to be connected to the penetrating wiring 154 that passes through from the front to the back of the Si substrate 153. Also at the back surface side of each photodiode 144 is formed the bump 155, connected to the penetrating wiring 154, and the intervals between the Si substrate 153 and the wirings 152 and the penetrating wirings 154 are insulated by the insulating films 156a, 156b, and 156c, which are silicon oxide films.

### Disclosure of the Invention

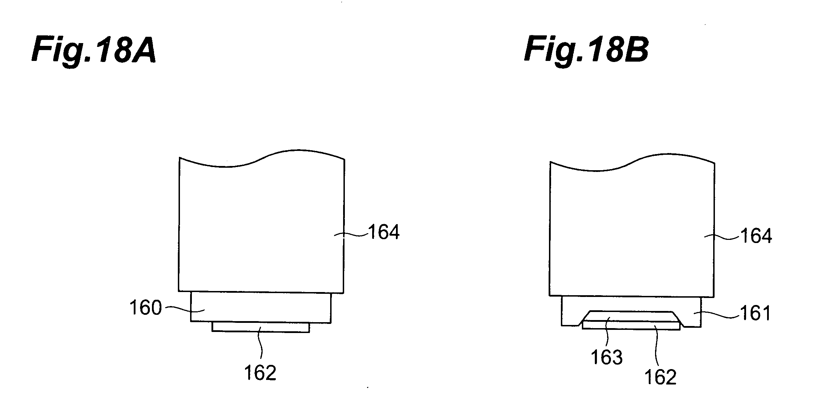

In mounting an above-described photodiode array, that is for example, the CT photodiode array, a flat collet or a pyramidal collet can be used as the collet for suctioning of the chip, and normally when flip-chip bonding is performed, a flat collet is used. The CT photodiode array is large in chip area (that is, for example, has a rectangular shape with one side being 20mm in length), and as shown in FIG. 18B, when the pyramidal collet 161 that is normally used in a mounter is used, warping occurs due to the gap 163 that forms between the chip 162 and the pyramidal collet 161 and positional deviation may occur due to this warping and cause lowering of the mounting precision. Also, heating and pressurization are required in the process of flip-chip bonding, and with the pyramidal collet 161, the heat conduction efficiency is poor and the edges of the chip may become damaged due to the applied pressure. The pyramidal collet 161 is thus not suited for a thin chip. Due to these reasons, in performing flip-chip bonding, heat and pressure are applied to the chip 162 from a heater block 164 while the suctioning chip 162 by the flat collet 160 that comes in planar contact with the chip surface as shown in FIG 18A.

However, when the flat collet 160 is used, the entire chip surface of the chip 162 contacts the flat collet 160. With this chip 162, the chip surface that contacts the flat collet 160 is the light-incident surface at which are formed the impurity diffusion layers that make up the photodetecting portion, that is, the photodiode array. If the entirety of this chip surface that is to be the light-incident surface is subject to pressurization and heating while being in contact with the flat collet 160, the photodetecting portion itself receives physical damage. Appearance defects and degradation of characteristics (increased dark current and noise, etc.) due to surface flaws thus occur at the photodetecting portion.

Thus an object of this invention is to provide a photodiode array, a manufacturing method thereof, and a radiation detector, with which the above issues are resolved and the degradation of characteristics due to damage of the photodiode array in the mounting process can be prevented.

In order to achieve the above object, this invention provides a photodiode array comprising: a semiconductor substrate, wherein a plurality of photodiodes are formed in array form on a surface onto which light to be detected is made incident; and penetrating wirings, passing through from the incidence surface side to a back surface side of the semiconductor substrate and being electrically connected to the photodiodes; and is characterized in that a recessed portion having a predetermined depth is formed on the incidence surface side of the semiconductor substrate and the photodiodes are formed in the recessed portion.

With this photodiode array, since the regions at which the photodiodes are not formed protrude further than the regions at which the photodiodes are formed, gaps form between the formed regions and a flat collet that is used for mounting due to the non-fonned regions. The formed regions thus do not contact the flat collet directly and are not subject to stress due to pressurization and heating.

Preferably with the above-mentioned photodiode array, a plurality of the above-mentioned recessed portions are formed and the adjacent recessed portions are in communication with each other. The above-mentioned recessed portions may be formed in a divided manner according to the respective photodiodes, adjacent recessed portions may be in communication with each other, and one photodiode may be formed in each recessed portion.

With each of these photodiode arrays, since adjacent recessed portions are in communication with each other, when a resin (for example, an optical resin used for mounting a scintillator panel) is coated onto the incidence surface side, the resin will flow thoroughly among the respective recessed portions and voids will not form readily inside the respective recessed portions.

Also preferably, the above-mentioned photodiode array is furthermore equipped with electrode wirings, formed on the above-mentioned incidence surface side of the semiconductor substrate and electrically connecting the photodiodes and the penetrating wirings, and the predetermined depth is set greater than the thickness of the electrode wirings. The photodiodes are thereby protected more securely by the non-formed regions. Furthermore, with each of these photodiode arrays, the semiconductor substrate has impurity regions (separation layers), which separate the respective photodiodes, disposed between the adjacent photodiodes. With these photodiode arrays, since surface leakage is restrained by the separation layers, adjacent photodiodes are electrically separated securely.

This invention provides a photodiode array manufacturing method comprising: a first step of forming, in a semiconductor substrate, formed of a semiconductor of a first conductive type, penetrating wirings that pass through between the respective surfaces of the semiconductor substrate; a second step of forming, at a predetermined region of a surface at one side of the semiconductor substrate, a recessed portion, which is depressed with respect to surrounding regions; and a third step of adding an impurity to the recessed portion to form a plurality of impurity diffusion layers of a second conductive type and forming a plurality of photodiodes arrayed in array form from the respective impurity diffusion layers and the semiconductor substrate.

With this photodiode array manufacturing method, a recessed portion that is depressed with respect to the surrounding regions is formed on the surface at one side of the semiconductor substrate, and the photodiode array, wherein the plurality of photodiodes are arrayed in array form, is formed in the recessed portion.

In the above-described photodiode array manufacturing method, the above-described first step may comprise: a step of forming a plurality of hole portions in the semiconductor substrate; a step of forming a conductive coating film on the surface of at least one side of the semiconductor substrate including the respective hole portions; and a step of polishing the semiconductor substrate to remove the conductive coating film.

With each of the above photodiode array manufacturing methods, subsequent the above-described first step, a step, of adding, between adjacent regions to which the impurity is to be added, another impurity to form impurity regions of the first conductive type, may be provided. With this manufacturing method, a photodiode array wherein adjacent photodiodes are separated securely can be provided.

Furthermore, this invention provides a radiation detector comprising: any of the above-described photodiode arrays; and a scintillator panel, mounted to the side of the photodiode array onto which the light to be detected is made incident and emits light due to incident radiation.

This invention also provides a radiation detector, comprising: the photodiode array manufactured by any of the above-described manufacturing methods; and a scintillator panel, mounted to the side of the photodiode array at which the above-mentioned recessed portion is formed and emits light due to incident radiation.

Since each of these radiation detectors is equipped with the above-described photodiode array, the photodiodes that are formed on the light-incident surface side are protected by the existence of non-formed regions and prevented from receiving damage due to pressurization and heating in the mounting process and degradation of characteristics due to the increase of noise and dark current, etc. due to such damage is prevented.

### Brief Description of the Drawings

FIG. 1 is a sectional view showing, in enlarged and schematic manner, the principal portions of a photodiode array of an embodiment.

FIG. 2 shows a side view of a semiconductor chip that makes up the photodiode array and sectional views showing the principal portions thereof in enlarged manner.

FIG. 3 is an enlarged sectional view of the principal portions that illustrates an intermediate step in a process of manufacturing the photodiode array of the embodiment.

FIG. 4 is an enlarged sectional view of the principal portions that illustrates a step subsequent that of FIG. 3.

FIG. 5 is an enlarged sectional view of the principal portions that illustrates a step subsequent that of FIG. 4.

FIG. 6 is an enlarged sectional view of the principal portions that illustrates a step subsequent that of FIG. 5.

FIG. 7 is an enlarged sectional view of the principal portions that illustrates a step subsequent that of FIG. 6.

FIG. 8 is an enlarged sectional view of the principal portions that illustrates a step subsequent that of FIG. 7.

FIG. 9 is an enlarged sectional view of the principal portions that illustrates a step subsequent that of FIG. 8.

FIG. 10 is an enlarged sectional view of the principal portions that illustrates a step subsequent that of FIG. 9.

FIG. 11 is an enlarged sectional view of the principal portions that illustrates a step subsequent that of FIG. 10.

FIG. 12 is a sectional view showing, in enlarged and schematic manner, the principal portions of another photodiode array of an embodiment.

FIG. 13 is a sectional view showing, in enlarged and schematic manner, the principal portions of yet another photodiode array of an embodiment.

FIG. 14 is a sectional view showing, in enlarged and schematic manner, the principal portions of yet another photodiode array of an embodiment.

FIG. 15 is a sectional view showing, in enlarged and schematic manner, the principal portions of a radiation detector having a photodiode array of an embodiment.

FIG. 16A is a plan view schematically showing a photodiode array of an embodiment and illustrates a case where the non-formed regions are provided as continuous and cross-intersection-like wall portions.

FIG. 16B is a plan view schematically showing a photodiode array of an embodiment and illustrates a case where the non-formed regions are provided as wall portions with which the portions besides the corner portions are connected intermittently.

FIG. 16C is a plan view schematically showing a photodiode array of an embodiment and illustrates a case where corner portions are provided as wall portions that are connected in cross-like form.

FIG. 17A is another plan view schematically showing a photodiode array of an embodiment and illustrates a case where rimmed wall portions are provided at positions at which the portions can surround the entirety of the formed regions.

FIG. 17B illustrates a case where wall portions that are partially omitted with respect to the wall portions of FIG. 17A are provided.

FIG. 17C illustrates a case where the wall portions of both FIG. 16A and 17A are provided.

FIG. 18A is a sectional view schematically showing a state wherein a semiconductor chip is suctioned by a collet and shows a state of suctioning by a flat collet.

FIG. 18B is a sectional view schematically showing a state wherein a semiconductor chip is suctioned by a collet and shows a state of suctioning by a pyramidal collet.

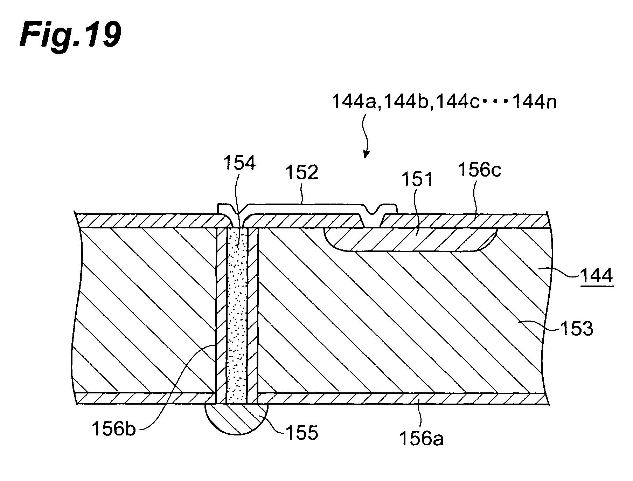

FIG. 19 is a sectional view showing a photodiode array of a conventional art.

### Best Modes for Carrying Out the Invention

Embodiments of this invention shall now be described. The same symbols shall be used for the same elements and redundant description shall be omitted.

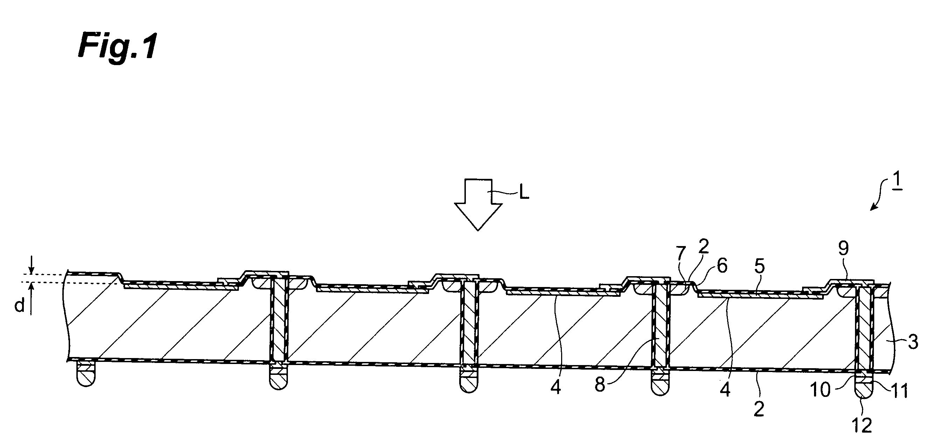

FIG. 1 is a sectional view that schematically shows the photodiode array 1 of an embodiment of this invention. In the description that follows, the surface of incidence of light L shall be called as the front surface and the surface at the opposite side shall be called as the back surface. In the respective FIGURES, the dimensions are differed as suited for the convenience of illustration.

Photodiode array 1 has the plurality of photodiodes 4, formed of pn junctions that are arrayed two-dimensionally in a regular array form in the vertical and horizontal directions, and each photodiode 4 functions as a single pixel of photodiode array 1, which, as a whole, makes up a single photodetecting portion.

The photodiode array 1 has the n-type (first conductive type) silicon substrate 3 with a thickness of approximately 150 to 500µm (preferably 400µm) and an impurity concentration of approximately 1 × 10¹² to 10¹⁵/cm³. The passivation films 2, formed of SiO₂ of a thickness of approximately 0.05 to 1µm (preferably 0.1µm), are formed on the front surface and back surface of the n-type silicon substrate 3. Also, on the front surface side of the photodiode array 1, a plurality of the recessed portions 6 are formed in a divided manner in accordance to the photodiodes 4.

Each recessed portion 6 is formed, for example, to a depressed rectangular shape of a size of 1mm × 1mm and has a predetermined depth. At a bottom portion of each is disposed the single p-type (second conductive type) impurity diffusion layer 5 with an impurity concentration of approximately 1 × 10¹⁵ to 10²⁰/cm³ and a depth of 0.05 to 20µm (preferably 0.2µm). The pn junctions, formed by these p-type impurity diffusion layers 5 and the n-type silicon substrate 3, are arrayed in a regular array form horizontally and vertically, and each junction makes up the photodiode 4.

The regions at which the respective p-type impurity diffusion layers 5 exist are the regions at which the photodiodes 4 are formed (formed regions), the regions besides these are non-formed regions where photodiodes are not formed, and the step difference between the two types of regions, that is the depth d of each recessed portion 6 is set greater than the film thickness of the electrode wirings 9 to be described later (for example to 0.05 to 30µm and preferably approximately 10µm).

The photodiode array 1 also has the penetrating wiring 8 provided for each photodiode 4. Each penetrating wiring 8 passes through from the front surface side to the back surface side of the n-type silicon substrate 3, is formed to a diameter of approximately 10µm to 100µm (preferably approximately 50µm), is formed of polysilicon with a phosphorus concentration of approximately 1 × 10¹⁵ to 10²⁰/cm³, has its front surface side electrically connected to the p-type impurity diffusion layer 5 via the electrode wiring 9 (with a film thickness of approximately 1µm) formed of aluminum, and has its back surface side electrically connected to the electrode pad 10 (with a film thickness of 0.05µm to 5µm and preferably approximately 1µm) formed likewise of aluminum. To each electrode pad 10, the solder bump electrode 12 is connected via an under-bump metal (UBM) 11, formed of Ni-Au. Though each penetrating wiring 8 is disposed in a non-formed region at which the photodiode 4 is not formed, it may be disposed in another portion instead.

The illustrated photodiode array 1 furthermore has n⁺-type impurity regions (separation layers) 7 provided to a depth of approximately 0.5 to 6µm between the p-type impurity diffusion layers 5, that is, between the adjacent photodiodes 4. This n⁺-type impurity region (separation layer) 7 has a function of electrically separating the adjacent photodiodes 4, and thus by the provision thereof, the adjacent photodiodes 4 are electrically separated securely and crosstalk among the photodiodes 4 can be reduced. However, even without the provision of the n⁺-type impurity regions 7, the photodiode array 1 has photodetecting characteristics that are adequately allowable in terms of practical use.

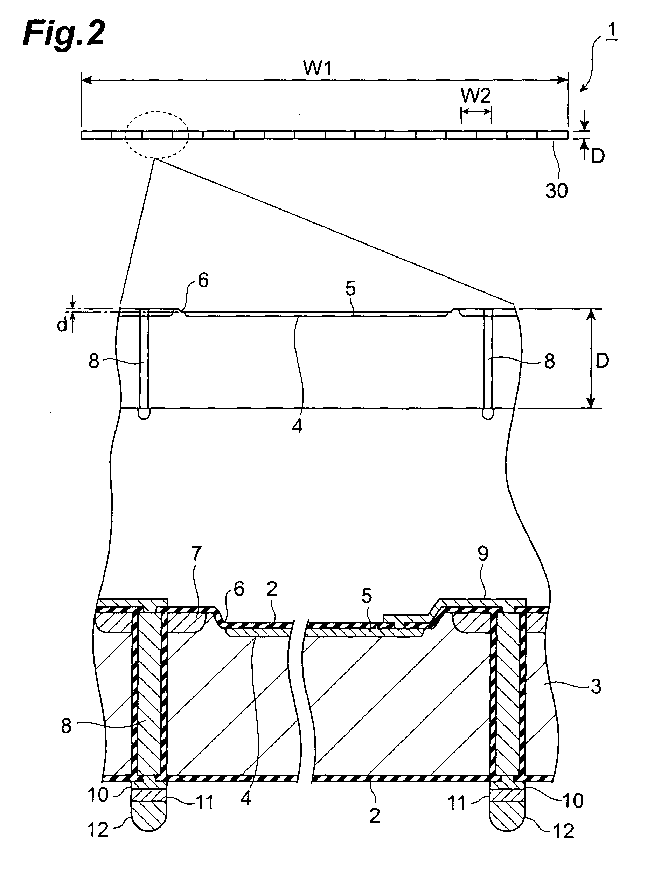

FIG. 2 shows a side view of the semiconductor chip 30 that makes up the photodiode array 1 and sectional views showing the principal portions thereof in enlarged manner. As shown in FIG. 2, the semiconductor chip 30 has an extremely thin, plate-like form with a width W1 of approximately 22.4mm and a thickness D of approximately 0.3mm, has a plurality of the above-described photodiodes 4 (for example, has a two-dimensional array of 16 × 16 photodiodes), and is a large area (for example, approximately 22.4mm × 22.4mm) chip wherein pitch W2 between adjacent pixels is approximately 1.4mm.

With the photodiode array 1 arranged as described above, when light L is made incident from the front surface side, this light L to be detected is made incident on the respective p-type impurity diffusion layers 5, and carriers corresponding to the incident light are generated by the respective photodiodes 4. The photocurrents due to the generated carriers are taken out from the bump electrodes 12 via the electrode wirings 9 and the penetrating wirings 8, connected to the respective p-type impurity diffusion layers 5 and furthermore via the respective electrodes pads 10 and the UBMs 11 at the back surface side. The incident light is detected by these outputs from the bump electrodes 12.

Since as described above, the photodiode array 1 has each photodiode 4 disposed at the bottom portion of a recessed portion 6, the region (non-formed region) surrounding the formed region of each photodiode 4 protrudes by an amount corresponding to depth d at the maximum. Thus with the photodiode array 1, when the semiconductor chip 30 is suctioned by a flat collet to perform flip-chip bonding, the non-formed regions contact the flat collet and function to secure gaps between the formed regions of the photodiodes 4 that make up the photodetecting portion and the flat collet. The formed regions are thus protected by the non-formed regions and do not directly contact the flat collet. With the photodiode array 1, since the photodetecting portion thus does not directly receive stress due to pressurization or stress due to heating, the photodetecting portion itself will not receive physical damage and the generation of noise and dark current due to such damage can be restrained. The photodiode array 1 can thus perform photodetecting of high precision (high S/N ratio).

Also besides flip-chip bonding, for example, when photodiode array 1 is integrated with a scintillator and used as a CT sensor as shall be described later, since the scintillator will not contact the photodetecting portion directly, damage in the process of mounting the scintillator can also be avoided.

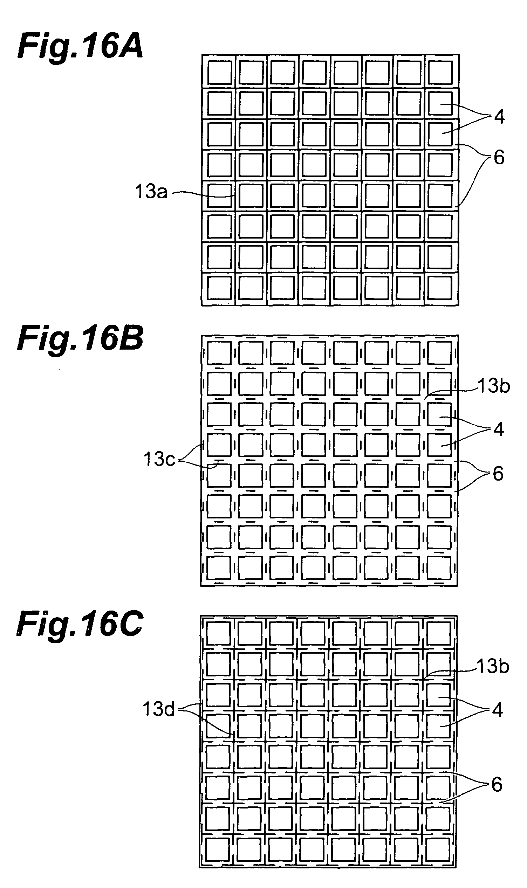

The above-mentioned recessed portions 6 are formed in a divided manner according to the respective photodiodes 4, and this can be achieved by forming the regions at which photodiodes are not formed as a plurality of continuous wall portions 13a, each having a step difference with respect to the formed regions and being positioned vertically and horizontally so as to intersect in cross-like manner as shown in FIG. 16A. Also, the non-formed regions may be formed as wall portions 13c disposed intermittently at portions besides the corner portions 13b as shown in FIG. 16B or as cross-like wall portions 13d positioned at corner portions 13b as shown in FIG. 16C. Also, though not illustrated, the recessed portions 6 may be formed in a divided manner in a plurality of regions, for example, by dividing them largely in two in the left/right direction, etc., and one or two or more photodiodes 4 may be formed in each recessed portion.

In a case where a plurality of the recessed portions 6 are formed in the above manner, the adjacent recessed portions 6 are made to communicate with each other without being partitioned completely by a non-formed region. For this purpose, the non-formed regions are formed, for example, by positioning the above-mentioned wall portions 13c or the cross-like wall portions 13d intermittently.

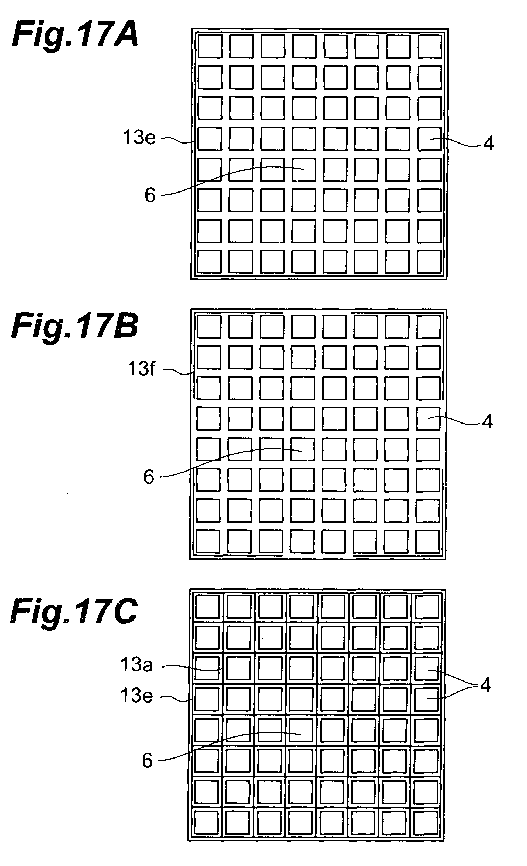

Also in place of making the adjacent recessed portions 6 communicate, frame-like wall portions 13e, which are rimmed, may be disposed at positions of the front surface side of n-type silicon substrate at which these portions will surround the entirety of the formed regions of the photodiodes 4 so that the entire inner side thereof will be the recessed portion 6 as shown in FIG. 17A. Or in place of these frame-like wall portions 13e, partially omitted frame-like wall portions 13f may be disposed as shown in FIG. 17B. In these cases, recessed portions 6 are formed without being partitioned from each other by the non-formed regions.

Meanwhile, not all of the non-formed regions need to be disposed at portions of greater film thickness than recessed portions 6, and portions thereof may be disposed in recessed portions 6 as shown in FIGS. 17A and 17B (just frame-like wall portions 13e and 13f are formed at portions of higher height with respect to the front surface and the other portions are formed in recessed portions 6). However, all photodiodes 4 must be disposed in recessed portions 6.

When as mentioned above, the non-formed regions are formed by positioning wall portions intermittently and the adjacent recessed portions 6 are made to communicate with each other without being partitioned, the gaps between adjacent wall portions function as relief paths for resin (for example, an optical resin 35 that is used to adhere the scintillator panel 31 to form the radiation detector 40 as shall be described later). Thus when a resin is coated onto the front surface side of the n-type silicon substrate 3, voids (pores) will not form readily (voids will be lessened) inside recessed portions 6 and the coated resin can be made to flow without bias and uniformly fill the respective recessed portions 6.

Also, though as shown in FIG. 17C, both the wall portions 13a and the frame-like wall portions 13e can be disposed, in this case, the respective recessed portions 6 will be partitioned completely by the non-formed regions.

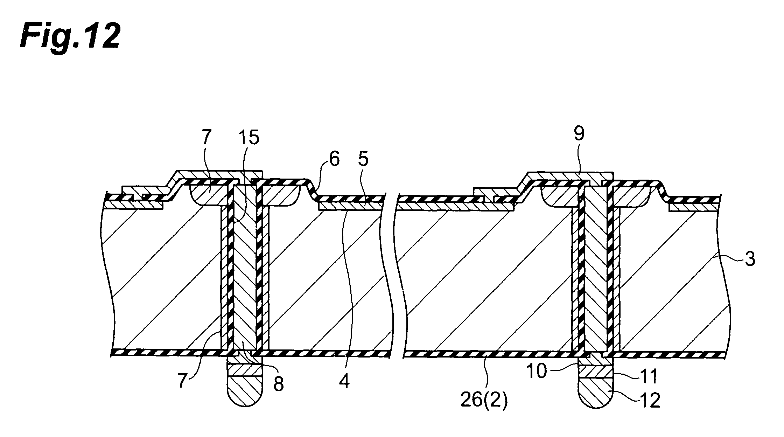

The above-described photodiode array 1 may also be arranged as follows. That is, for example as shown in FIG. 12, phosphorus may be diffused in side walls of the pore portions 15 to provide the n⁺-type impurity regions 7 at the surroundings of the penetrating wirings 8 as well. Unnecessary carriers from damaged layers formed in the process of forming the pore portions 15 (hole portions 14) can thereby be trapped to restrain the dark current. The concentration of phosphorus to be added in this case is set to approximately 1 × 10¹⁵ to 10²⁰/cm³ and the thickness (depth) of each n⁺-type impurity region 7 is set to approximately 0.1 to 5µm.

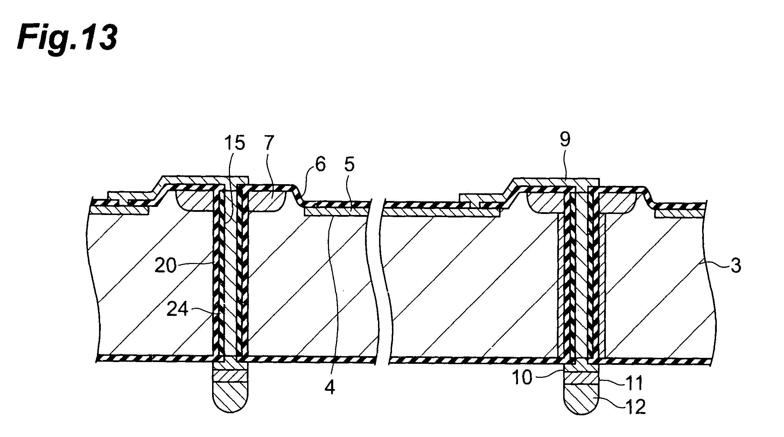

Also as shown in FIG. 13, a silicon nitride film 24 with a film thickness of approximately 0.1 to 2µm may be disposed on a silicon oxide film 20 inside each pore portion 15 as shown in FIG. 13. By doing so, the insulation between n-type silicon substrate 3 and penetrating wirings 8 can be secured to reduce operation faults.

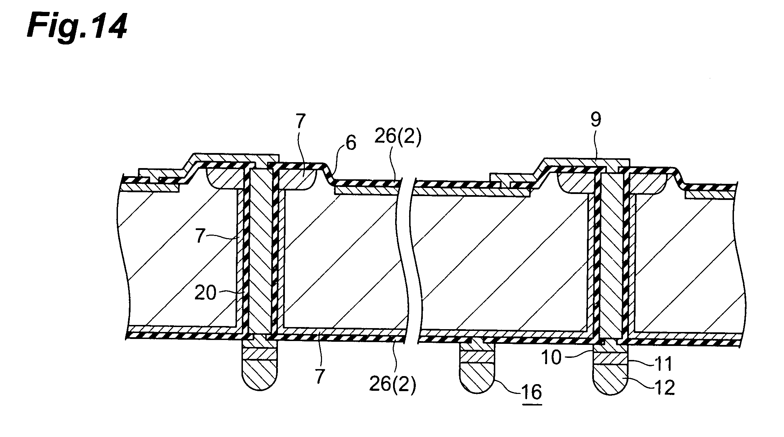

Furthermore, the n⁺-type impurity regions 7 may also be provided at the back surface side by doping and diffusing phosphorus as shown in FIG. 14. In this case, cathode electrodes 16 can be led out from the back surface. By doing so, the need to provide penetrating wirings for the cathode is eliminated, thus leading to the lowering of damage, the lowering of dark current, and the lowering of the percent defective. Needless to say, electrodes to serve as cathodes may also be disposed at the back surface side upon providing penetrating wirings from the n⁺-type impurity regions 7 formed on the front surface.

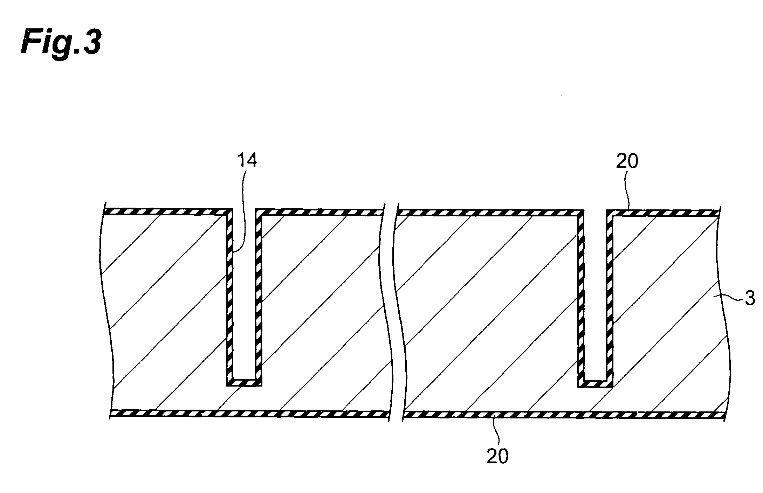

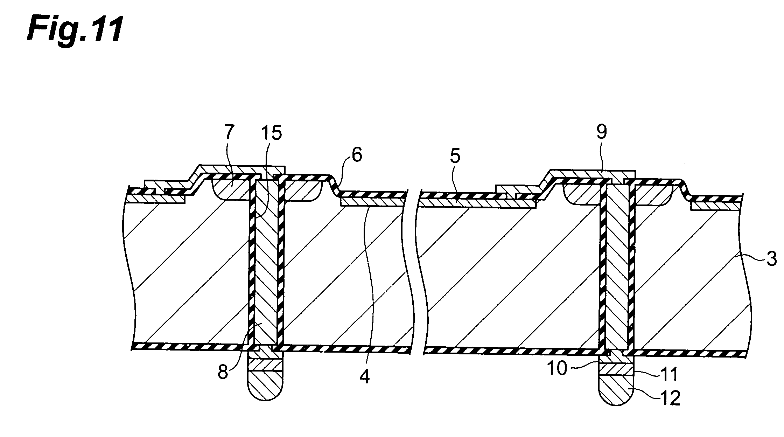

A method of manufacturing the present embodiment's photodiode array I shall now be described with reference to FIGS. 3 to 11.

First, the n-type silicon substrate 3 with a thickness of approximately 150 to 500µm (preferably 400µm) is prepared. Then as shown in FIG. 3, by ICP-RIE, a plurality of the hole portions 14, which are of a diameter of approximately 10µm to 100µm (preferably 50µm) and do not pass through, are formed in correspondence to the photodiodes 4 to a depth (for example of approximately 100 to 350µm) that is in accordance to the thickness of the n-type silicon substrate 3 at a surface at one side (this surface shall hereinafter be the front surface and the surface at the opposite side shall be the back surface) of the n-type silicon substrate 3, and thereafter the front surface and the back surface of the substrate are thermally oxidized to form the silicon oxide films (SiO₂) 20. In each hole portion 14, the penetrating wiring 8 is formed in a later step. The silicon oxide film (SiO₂) 20 realizes the electrical insulation between the penetrating wirings 8 to be described later and n-type silicon substrate 3.

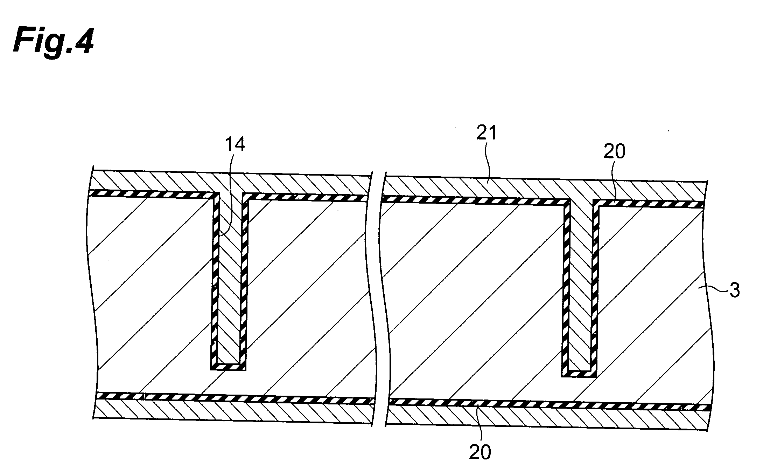

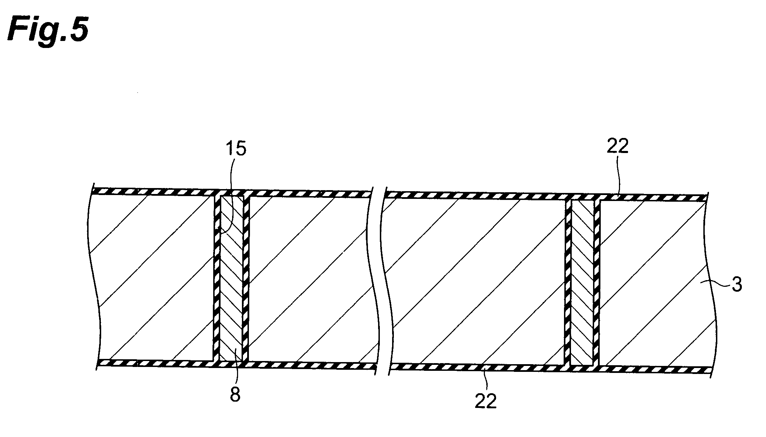

Then, as shown in FIG. 4, at the same time as forming a polysilicon film 21 on the front surface and the back surface or just the front surface of the substrate as a conductive coating film having phosphorus added as an impurity, the hole portions 14 are filled by polysilicon that has been made low in resistance by the addition of the impurity. Subsequently as shown in FIG.5, the front surface and the back surface of the substrate are polished to remove the polysilicon film 21 that had been formed on the front surface and the back surface and expose the polysilicon embedded in the hole portions 14 at the front surface and the back surface and thereby form the pore portions 15 passing through between the surfaces at both sides and make the embedded polysilicon become the penetrating wirings 8. The front surface and the back surface of the substrate are then thermally oxidized again to form the silicon oxide films 22. These silicon oxide films 22 are used as n⁺ thermal diffusion masks in a subsequent step.

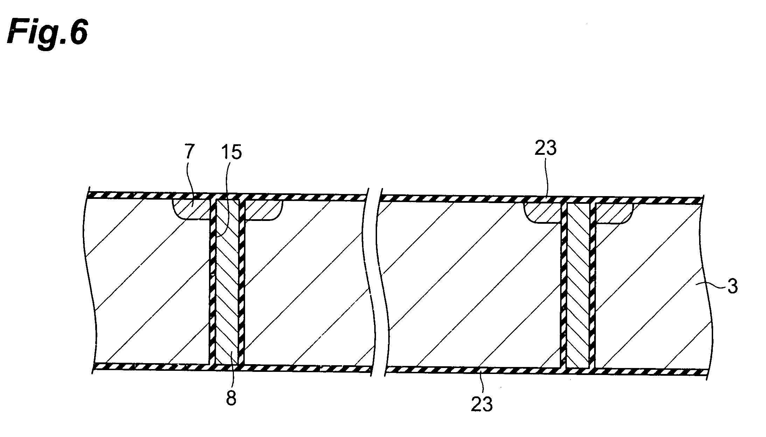

The silicon oxide film 22 at the front surface side of the n-type silicon substrate 3 is then patterned using a predetermined photomask to open just the regions at which the n⁺-type impurity regions 7 are to be provided, and phosphorus is diffused from the opened portions (open portions) to provide the n⁺-type impurity regions 7 (in the case where the n⁺-type impurity regions 7 are not to be provided this step (impurity region forming step) may be omitted). Thereafter, the front surface and the back surface of the substrate are thermally oxidized again to form the silicon oxide films 23 (see FIG. 6). These silicon oxide films 23 are used as masks in the process of forming the p-type impurity diffusion layers 5.

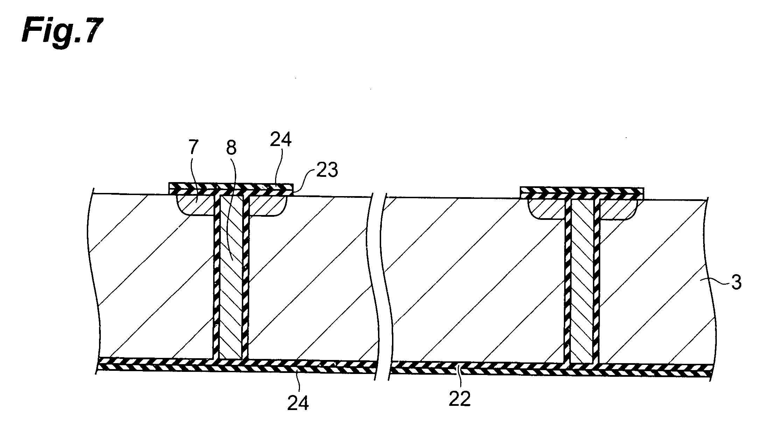

Then upon forming the silicon nitride films (SiN) 24 by LP-CVD (or plasma CVD) on the front surface and the back surface of the n-type silicon substrate 3, patterning using a predetermined photomask is performed as shown in FIG. 7 to remove the silicon nitride film 24 and the silicon oxide film 23 from portions corresponding to the respective recessed portions 6 while leaving the silicon nitride film 24 and the silicon oxide film 23 just at portions at which the recessed portions 6 are not to be formed. In this step, by suitably changing the regions at which the silicon nitride film 24 and the silicon oxide film 23 are left, the non-formed regions can be formed in any of the various patterns described above.

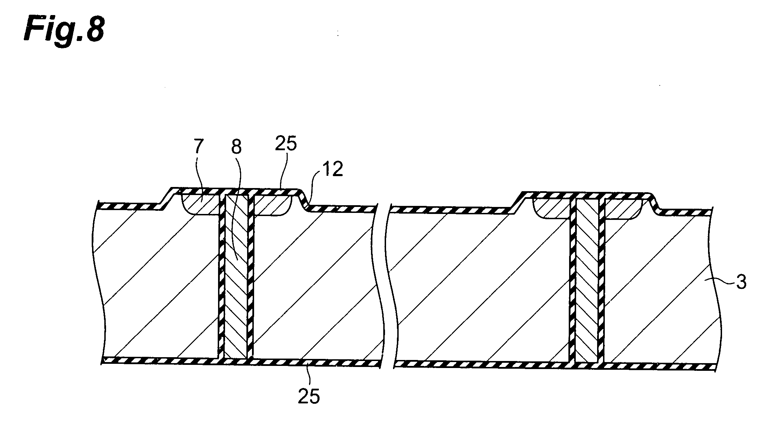

Then using a potassium hydroxide solution (KOH) or TMAH or other silicon etching solution and using the remaining silicon nitride film (SiN) 24 and the silicon oxide film 23 as masks, anisotropic etching targeted at the n-type silicon substrate 3 is performed, and then after performing thermal oxidation, the remaining silicon nitride (SiN) film 24 is removed. By this step, portions that were not covered by the silicon nitride film (SiN) 24 (and silicon oxide film 23) become depressed in comparison to the surrounding regions, and the above-described recessed portions 6 are thereby formed. By the above-mentioned thermal oxidation, the silicon oxide film 23 becomes joined with the silicon oxide films formed in the recessed portions 6, thereby forming the silicon oxide films 25 (see FIG. 8). This passivation film 2 on the respective p-type impurity diffusion layers 5 also provides the effect of an antireflection film, and by changing the thickness thereof, a high photodetecting sensitivity for a desired wavelength can be obtained.

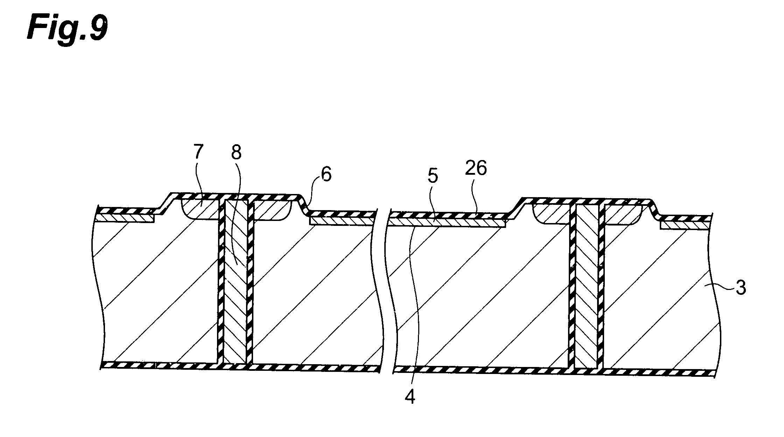

The silicon oxide film 25 is then patterned using a predetermined photomask and just the regions at the bottom portions of the respective recessed portions 6 at which the respective p-type impurity diffusion layers 5 are to be formed are opened. Boron is then diffused from the opened portions and the p-type impurity diffusion layers 5 are formed so as to be arrayed vertically and horizontally in a two-dimensional array. Thereafter, the front surface and the back surface of the substrate are thermally oxidized again to form the silicon oxide films 26 (see FIG. 9). These silicon oxide films 26 become passivation films 2. This passivation film 2 on the respective p-type impurity diffusion layers 5 also provides the effect of an antireflection film, and by changing the thickness thereof, a high photodetecting sensitivity for a desired wavelength can be obtained. The photodiodes 4, formed by the pn junctions of the respective p-type impurity diffusion layers 5 and the n-type silicon substrate 3 are thus formed so as to be arrayed vertically and horizontally in a two-dimensional array at the bottom portions of the recessed portions 6 and these photodiodes 4 become portions corresponding to pixels.

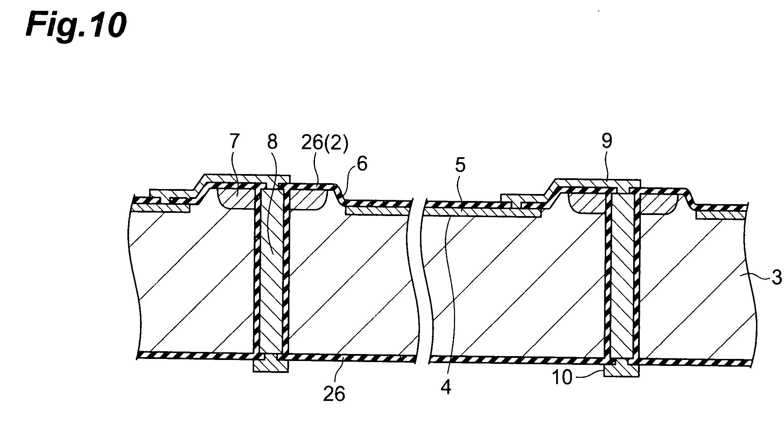

Furthermore by a photoetching technique, contact holes are formed at regions at which the respective penetrating wirings 8 are formed. Subsequently, upon forming aluminum metal films over the entireties of the front surface and the back surface, patterning is performed using a predetermined photomask, and by a photoetching technique, unnecessary portions of the metal film are removed to form the electrode wirings 9 at the front surface side and the electrode pads 10 at the back surface side (see FIG. 10).

The bump electrodes 12 are then provided at the respective electrode pads 10, and in the case where solder is to be used as the bump electrodes 12, since solder is poor in wettability with respect to aluminum, the UBMs 11 for intervening between the respective electrode pads 10 and bump electrodes 12 are formed on the respective electrode pads 10 and bump electrodes 12 are formed overlappingly on UBMs 11. By the above steps, a photodiode array 1, with which noise due to damage during mounting will not be generated and which enables photodetection of high precision, can be manufactured.

Though in this case, the UBMs 11 are formed by electroless plating and using Ni-Au, the UBMs may be formed instead by the lift-off method and using Ti-Pt-Au or Cr-Au. In the case where the UBMs 11 are to be formed by electroless plating, plating must be performed upon protecting the front surface and the back surface while exposing just the portions at which the UBMs 11 are to be formed, that is, just the respective electrode pads 10. In the embodiment, since the electrode wirings 9 are exposed on the front surface, SiO₂ or SiN may be formed on the front surface by a resist and plasma CVD, etc. in performing plating. In the case where SiO₂ or SiN is used, these may be left on without being removed if it is judged that these will not affect the optical characteristics of the photodiodes. The electrode wirings 9 on the front surface can thereby be protected, and furthermore by the protection of the photodiodes, the reliability is improved. Also, the bump electrodes 12 are obtained by forming solder on predetermined the UBMs 11 by a solder ball mounting method or printing method and performing reflow. The bump electrodes 12 are not limited to those formed of solder and may be gold bumps, nickel bumps, or copper bumps or even conductive resin bumps, which contain a conductive filler or other metal.

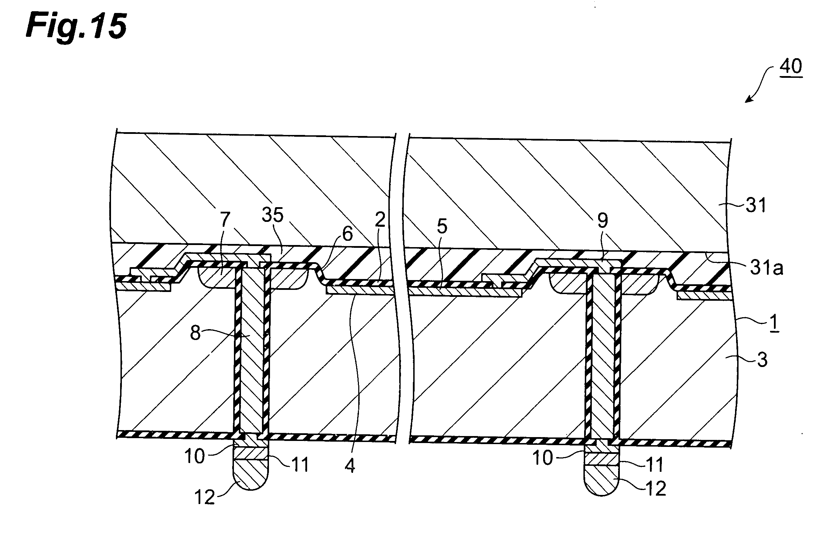

An embodiment of this invention's radiation detector shall now be described. FIG. 15 is sectional side view of the radiation detector 40 of the embodiment. This radiation detector 40 has the scintillator panel 31, onto which radiation is made incident and which emits light, generated as a result of the radiation, from a light emitting surface 31a, and the above-described photodiode array 1, onto which the light emitted from the scintillator panel 31 is made incident and which converts the light to electrical signals. This radiation detector 40 is characterized in having this invention's photodiode array 1.

The scintillator panel 31 is mounted to the front surface side (incidence surface side) of photodiode array 1, and photodiode array 1 has the above-described recessed portions 6 disposed at its front surface side. Though the back surface of the scintillator 31, that is, light emitting surface 31a will thus contact the non-formed regions of the photodiode array 1, it will not contact the formed regions of the photodiodes 4 directly. Also, though gaps are formed between light emitting surface 31a of the scintillator panel 31 and the recessed portions 6, an optical resin 35, having a refractive index such that will prevent the degradation of the light transmitting characteristics, is filled in these gaps. By the optical resin 35, the light emitted from the scintillator panel 31 is made incident on the photodiode array 1 efficiently. As this optical resin 35, an epoxy resin, acrylic resin, urethane resin, silicone resin, fluorine resin, etc., having the property of transmitting the light emitted from the scintillator panel 31, may be used or a composite material having these resins as the base material may be used.

In bonding the photodiode array 1 onto an unillustrated mounting wiring substrate, the front surface is suctioned by a flat collet. However, since the above-described recessed portions 6 are provided on the front surface of the photodiode array 1, the suctioning surface of the flat collet will not contact the photodetecting portion directly, and direct contacting of light emitting surface 31a with the formed regions of the photodiodes 4 due to the mounting of the scintillator 31 will also not occur. Since with the radiation detector 40, having such the photodiode array 1 and the scintillator panel 31, the generation of noise, dark current, etc. due to the damaging of the photodetecting portion in the mounting process can be prevented, photodetection can be performed with high precision and the detection of radiation can also be performed at high precision.

### Industrial Applicability

As has been described in detail above, by the present invention, the generation of noise, dark current, etc. due to the damaging of the photodetecting portion in the mounting process can be prevented effectively in a photodiode array, a method of manufacturing the same, and a radiation detector.

## Claims

1. A photodiode array comprising:
a semiconductor substrate, wherein a plurality of photodiodes are formed in array form on a surface onto which light to be detected is made incident; and
penetrating wirings, passing through from the incidence surface side to a back surface side of the semiconductor substrate and being electrically connected to the photodiodes; and
**characterized in that** a recessed portion having a predetermined depth is formed on the incidence surface side of the semiconductor substrate and the photodiodes are formed in the recessed portion.

2. The photodiode array according to Claim 1, wherein a plurality of the recessed portions are formed and adjacent recessed portions are in communication with each other.

3. The photodiode array according to Claim 1, wherein
the recessed portions are formed in divided manner according to the respective photodiodes, adjacent recessed portions are in communication with each other, and one photodiode is formed in each of the recessed portions.

4. The photodiode array according to any of Claims 1 through 3, further comprising:
electrode wirings, formed on the incidence surface side of the semiconductor substrate and electrically connecting the photodiodes and the penetrating wirings, and wherein the predetermined depth is set greater than the thickness of the electrode wirings.

5. The photodiode array according to any of Claims 1 through 4, wherein the semiconductor substrate has impurity regions, which separate the respective photodiodes, disposed between the adjacent photodiodes.

6. A photodiode array manufacturing method comprising:
a first step of forming, in a semiconductor substrate, formed of a semiconductor of a first conductive type, penetrating wirings that pass through between the respective surfaces of the semiconductor substrate;
a second step of forming, at a predetermined region of a surface at one side of the semiconductor substrate, a recessed portion, which is depressed with respect to surrounding regions; and
a third step of adding an impurity to the recessed portion to form a plurality of impurity diffusion layers of a second conductive type and forming a plurality of photodiodes arrayed in array form from the respective impurity diffusion layers and the semiconductor substrate.

7. The photodiode array manufacturing method according to Claim 6, wherein
the first step comprises: a step of forming a plurality of hole portions in the semiconductor substrate; a step of forming a conductive coating film on the surface of at least one side of the semiconductor substrate including the respective hole portions; and a step of polishing the semiconductor substrate to remove the conductive coating film.

8. The photodiode array manufacturing method according to Claim 6 or 7, wherein subsequent the first step is provided a step, of adding, between adjacent regions to which the impurity is to be added, another impurity to form impurity regions of the first conductive type.

9. A radiation detector comprising:
the photodiode array according to any of Claims 1 through 5; and a scintillator panel, mounted to the side of the photodiode array onto which the light to be detected is made incident and emits light due to incident radiation.

10. A radiation detector comprising:
the photodiode array manufactured by the manufacturing method according to any of Claims 6 through 8; and
a scintillator panel, mounted to the side of the photodiode array at which the the recessed portion is formed and emits light due to incident radiation.
